**Europäisches Patentamt**

**European Patent Office**

**Office européen des brevets**

(19)

(11) Veröffentlichungsnummer: **0 135 869**
**B1**

(12) **EUROPÄISCHE PATENTSCHRIFT**

(45) Veröffentlichungstag der Patentschrift:
03.08.88

(51) Int. Cl.⁴: **G 01 R 31/28**

(21) Anmeldenummer: **84110637.0**

(22) Anmeldetag: **06.09.84**

(54) Verfahren und Vorrichtung zur Messung eines in einer Schaltung auftretenden elektrischen Signals.

(30) Priorität: **23.09.83 DE 3334530**

(43) Veröffentlichungstag der Anmeldung:
**03.04.85 Patentblatt 85/14**

(45) Bekanntmachung des Hinweises auf die Patenterteilung:
**03.08.88 Patentblatt 88/31**

(84) Benannte Vertragsstaaten:
**AT BE CH DE FR GB IT LI LU NL SE**

(56) Entgegenhaltungen:
**DE - A - 3 040 733**

(73) Patentinhaber: **Siemens Aktiengesellschaft Berlin und München, Wittelsbacherplatz 2, D-8000 München 2 (DE)**

(72) Erfinder: **Fazekas, Peter, Dipl.-Ing., Stuntzstrasse 21, D-8000 München 80 (DE)**

# Beschreibung

Die Erfindung betrifft ein Verfahren zur Messung eines in einer Schaltung auftretenden elektrischen Signals nach dem Oberbegriff des Anspruchs 1 sowie eine Vorrichtung zur Durchführung des Verfahrens nach dem Oberbegriff des Anspruchs 3.

Wird beispielsweise mit einer Elektronensonde ein Zustandsdiagramm von elektrischen Signalen an mindestens einem Schaltungsknoten von integrierten Schaltungen im Sampling-Verfahren aufgezeichnet, so wird das Abtastfenster in nichtlinearer Weise über den Schaltungszyklus geschoben (siehe US-Patentschrift US-A-4 220 854). Dabei wird das elektrische Signal zyklisch an den Messpunkt angelegt. Jedes Mal, wenn der Grundtakt der integrierten Schaltung eine Anstiegsflanke oder eine Abstiegsflanke aufweist, wird dabei üblicherweise nach dem Stand der Technik das an dem Messpunkt anliegende Potential durch mehrmaliges Abtasten (sampling) bei einer bestimmten Phase des elektrischen Signals gemessen. Es werden dabei also nur diejenigen Phasenpunkte des elektrischen Signals von diesem bekannten Messverfahren erfasst, die mit einer Anstiegsflanke oder mit einer Abfallflanke des Grundtaktes der integrierten Schaltung zusammenfallen. Bei diesem bekannten Verfahren können zwar die logischen Zustandsänderungen, die an dem jeweiligen Messpunkt auftreten, exakt erfasst werden, weil diese logischen Zustandsänderungen mit Anstiegsflanken oder mit Abfallflanken des Grundtaktes der integrierten Schaltung zusammenfallen. Treten aber kurze Störimpulse (spikes) auf, die nicht mit Anstiegsflanken oder Abfallflanken des Grundtaktes der integrierten Schaltung zusammenfallen, so werden diese Störimpulse von dem bekannten Messverfahren nicht erfasst. Nur dann, wenn Störimpulse zufällig mit einem Abtastzeitpunkt zusammenfallen, können solche Störimpulse bei Durchführung des bekannten Messverfahrens erfasst werden.

Um kurze Störimpulse, die nicht bei einer Anstiegsflanke oder Abfallflanke des Grundtaktes einer integrierten Schaltung auftreten, erfassen zu können, war es bisher notwendig, Zeitdiagramme der elektrischen Signale an Schaltungsknoten von integrierten Schaltungen aufzuzeichnen. Das bedeutet, dass der gesamte Schaltungszyklus linear aufgezeichnet wurde. Dabei wurde das elektrische Signal an einem Schaltungsknoten einer integrierten Schaltung zu jedem Phasenpunkt, der messtechnisch von einem anderen Phasenpunkt unterscheidbar ist, in gleicher Weise gemessen und aufgezeichnet. Wenn ein elektrisches Signal an einem Messpunkt in einer integrierten Schaltung an sämtlichen Phasenpunkten, die messtechnisch voneinander unterscheidbar sind, gemessen wird, ist der Zeitaufwand für eine solche Gesamtaufzeichnung des elektrischen Signals jedoch sehr gross.

Der vorliegenden Erfindung liegt die Aufgabe zugrunde, ein Verfahren der eingangs genannten Art anzugeben, mit dem ein während der Aufzeichnung eines elektrischen Signals auftretendes Störsignal registriert werden kann. Weiterhin soll eine Vorrichtung zur Durchführung eines solchen Verfahrens angegeben werden.

Diese Aufgaben werden erfindungsgemäss durch ein Verfahren nach Anspruch 1 und eine Vorrichtung nach Anspruch 3 gelöst.

Ausgestaltungen und Vorteile der Erfindung sind im Unteranspruch, der Beschreibung und der Zeichnung dargestellt.

Bei der Durchführung eines erfindungsgemässen Verfahrens kann man anstelle der Elektronensonde beispielsweise auch den Laserstrahl eines Laser-Scanners oder jede andere Sonde verwenden, die die Aufzeichnung eines in einer Schaltung auftretenden elektrischen Signals gestattet. Das erfindungsgemässe Verfahren kann man auch zur Aufzeichnung eines in einer integrierten Schaltung oder an deren Ausgängen auftretenden elektrischen Signals verwenden. Es ist grundsätzlich auch zur Aufzeichnung von elektrischen Signalen verwendbar, die an beliebigen elektrischen Leitungen festgestellt werden können.

Die Erfindung wird im folgenden anhand der Zeichnung näher erläutert.

Fig. 1 zeigt ein Ausführungsbeispiel einer Vorrichtung zur Durchführung eines erfindungsgemässen Verfahrens.

Fig. 2 zeigt die mit einem bekannten Verfahren ohne Störsignalregistrierung gewonnenen Zeitdiagramme.

Fig. 3 zeigt den Phasenverlauf für eine Messwerterfassung mit dem bekannten Verfahren nach Fig. 2.

Fig. 4 zeigt die mit einem erfindungsgemässen Verfahren mit Störsignalregistrierung gewonnenen Signale.

Fig. 5 zeigt den Phasenverlauf bei der Messwerterfassung mit Hilfe eines erfindungsgemässen Verfahrens.

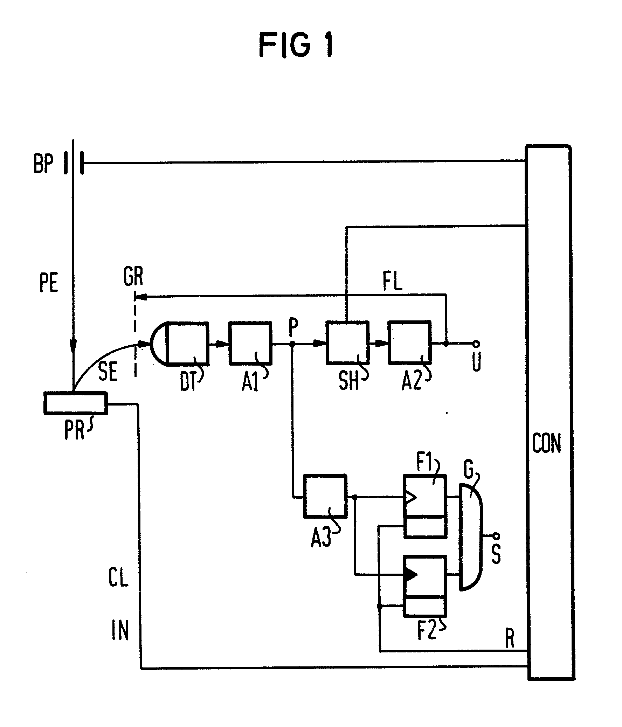

Fig. 1 zeigt ein Blockschaltbild eines Beispiels für eine Vorrichtung zur Durchführung eines erfindungsgemässen Verfahrens. In diesem Beispiel ist eine Vorrichtung dargestellt, die auf einer bekannten Messeinrichtung zur Durchführung eines Sampling-Verfahrens mit Hilfe einer Elektronensonde aufbaut. Eine Vorrichtung zur Durchführung eines Sampling-Verfahrens mit Hilfe einer Elektronensonde ist beispielsweise aus der bereits zitierten US-Patentschrift US-A-4 220 854 bekannt. In dieser Patentschrift wird auch die Durchführung eines Sampling-Verfahrens beschrieben. Eine etwas verbesserte Vorrichtung zur Durchführung eines Sampling-Verfahrens ist auch noch aus der US-Patentschrift US-A-4 277 679 bekannt. Bei einer solchen bekannten Vorrichtung zur Durchführung eines Sampling-Verfahrens werden über eine Ablaufsteuerung CON synchron mit dem an eine Probe PR, beispielsweise eine integrierte Schaltung, angelegten Grundtakt CL Primärelektronen PE mittels einer Elektronenstrahl-Austastvorrichtung BP zu Abtastimpulsen EP geformt. Diese Abtastimpulse EP treffen bei jeder Anstiegsflanke und bei jeder Abfallflanke des Grundtaktes CL auf einen Messpunkt auf der Probe PR auf. An diesem Messpunkt auf der Probe PR liegt ein zyklisches Signal SI an. Dieses zyklische Signal SI wird dadurch nachgewiesen, dass beim Auftreffen der Primärelektronen PE auf den Messpunkt Sekundärelektronen SE ausgelöst werden, die in einem Detektor DT nachgewiesen und in ein Sekundärelektronen-Messsignal umgeformt werden. Dieses Messsignal wird zunächst in einem Vorverstärker A1 verstärkt. Bei dem bekannten Sampling-Verfahren wird das Signal SI bei ein und demselben Phasenpunkt mehrmals hintereinander abgetastet, um ein gutes Signal-Rausch-Verhältnis bei der Bestimmung des zu einem bestimmten Phasenpunkt des Signals SI zugehörigen Potentials auf dem Messpunkt auf der Probe PR zu erhalten. Die Messsignale, die zu ein und demselben Phasenpunkt des Signals SI gehören, werden in einer Schaltung SH, beispielsweise einer Sample-and-Hold-Schaltung oder einer integrierenden Schaltung (Boxcar-Integrator), aufsummiert. Das Ergebnis dieser Aufsummation wird sodann in einem weiteren Verstärker A2 nochmals verstärkt. Am Ausgang U dieses zweiten Verstärkers A2 erhält man schliesslich das Messergebnis für das Potential, welches an dem Messpunkt auf der Probe PR an einem bestimmten Phasenpunkt des Signals SI anliegt.

Um das Messergebnis am Ausgang U zu linearisieren, wird die Messkette, bestehend aus Detektor DT, Verstärker A1, integrierende Schaltung SH und Verstärker A2 zu einem Regelkreis FL geschlossen, der die Spannung an einem retardierenden Gitter GR in einem retardierenden Spektrometer zur Bestimmung der Sekundärelektronen-Energien steuert.

Zur Durchführung eines erfindungsgemässen Verfahrens wird das Messsignal an einem Punkt P zwischen dem Vorverstärker A1 und der integrierenden Schaltung SH abgegriffen und beispielsweise einem weiteren Verstärker A3 zugeführt. Der Ausgang dieses weiteren Verstärkers A3 wird auf die flankengesteuerten Setz-Eingänge zweier RS-Flipflops F1, F2 geführt. Die Ausgänge dieser beiden Flipflops F1, F2 werden in einem logischen UND-Verknüpfungsglied G verknüpft. Der Ausgang dieses logischen UND-Verknüpfungsgliedes G zeigt schliesslich an, ob ein Störsignal in einem Bereich zwischen zwei Flanken des Grundtaktes CL der Probe PR aufgetreten ist oder nicht.

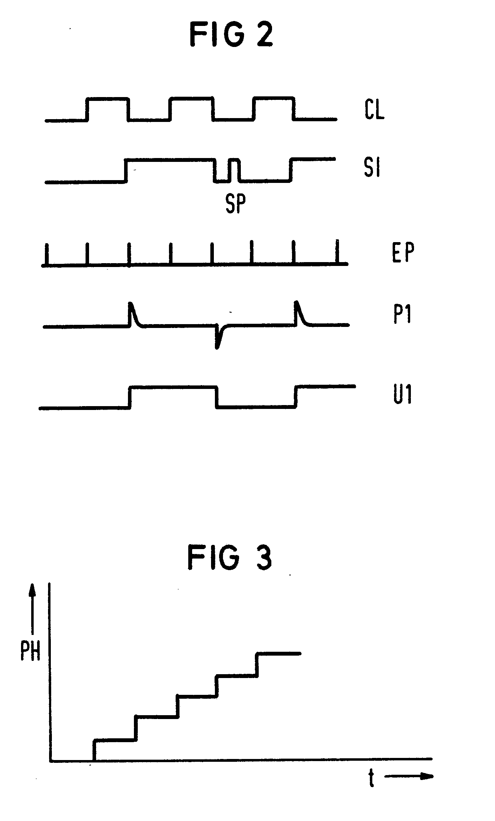

Die Fig. 2 und 3 erläutern die Funktion einer bekannten Vorrichtung nach dem Sampling-Verfahren, die ein zwischen Taktflanken des Grundtaktes CL auftretendes Störsignal nicht nachzuweisen erlaubt. Fig. 2 zeigt den Grundtakt CL an der Probe PR, das Signal SI, das an einem Messpunkt in zyklischer Weise angelegt ist und das ein Störsignal SP aufweist, die Primärelektronen-Abtastimpulse EP, die bei jeder Flanke des Grundtaktes CL auftreten, das Messsignal am Messpunkt P und das Messergebnis U1 am Ausgang U. Wie das Ergebnis U1 zeigt, kann mit einem bekannten Verfahren und einer bekannten Vorrichtung das Störsignal SP im Signal SI nicht nachgewiesen werden.

Wie Fig. 3 zeigt, werden bei einem bekannten Verfahren die Phasen PH der Phasenpunkte, an denen über einen endlichen Zeitbereich hinweg mehrmals hintereinander das Signal SI abgetastet wird, schrittweise über den ganzen Zyklus des zyklischen Signals SI hinweg geschoben. Zwischen den einzelnen Phasen verschiedener aufeinanderfolgender Phasenpunkte treten dabei jeweils erhebliche Abstände auf, so dass bei einer Aufzeichnung eines zyklischen Signals SI nur einige wenige Phasenpunkte erfasst werden.

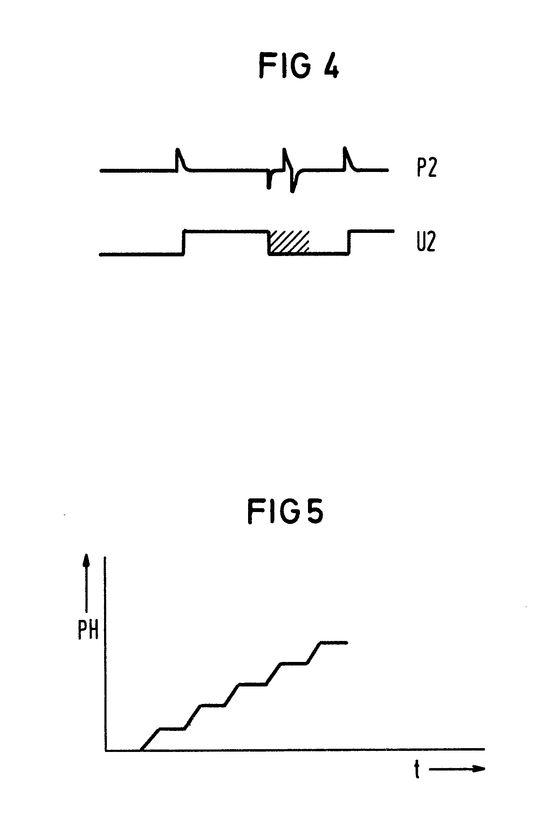

Die Fig. 4 und 5 zeigen, welche Verbesserungen mit einem erfindungsgemässen Verfahren erzielt werden können, und auf welche Weise diese Verbesserungen erzielt werden können. Fig. 4 zeigt ein Messsignal P2, welches mit einer Vorrichtung zur Durchführung eines erfindungsgemässen Verfahrens am Punkt P abgenommen werden kann. Bei einem erfindungsgemässen Verfahren wird, wie in Fig. 5 gezeigt wird, die Phase PH, bei der die Abtastimpulse EP das zyklische Signal SI am Messpunkt abtasten, nicht in grossen Stufen schrittweise verändert, wie dies für ein bekanntes Verfahren in Fig. 3 dargestellt ist, sondern es werden einzelne Phasenpunkte des zyklischen Signals SI herausgegriffen, an denen die Phase PH über eine längere Zeit t hinweg konstant bleibt, was bedeutet, dass diese Phasenpunkte mehrmals hintereinander zur Gewinnung eines wohldefinierten Potentialwertes, den der Messpunkt an diesem Phasenpunkt des Signals SI aufweist, abgetastet werden. Zwischen jeweils zwei solchen Phasenpunkten, an denen wohldefinierte Potentialwerte U gewonnen werden, werden sämtliche messtechnisch unterscheidbare Phasenpunkte nur jeweils solange abgetastet, bis festgestellt werden kann, ob an diesen Phasenpunkten ein Störsignal vorliegt oder nicht. An diesen zuletzt genannten Phasenpunkten des zyklischen Signals SI wird also keineswegs solange abgetastet, bis infolge eines guten Signal-Rausch-Verhältnisses ein wohldefinierter Potentialwert am Ausgang U angegeben werden kann, sondern nur solange, bis am Ausgang S angegeben werden kann, ob im Zwischenbereich zwischen zwei Taktflanken des Grundtaktes CL ein Störsignal vorliegt oder nicht.

Bei Durchführung eines erfindungsgemässen Verfahrens wird das zyklische Signal SI also auch an solchen Phasenpunkten abgetastet, an denen der Anstieg und der Abfall des Störsignals SP festgestellt werden können. Trifft bei der Anstiegsflanke des Störsignals SP ein Primärelektronen-Abtastimpuls EP auf den Messpunkt, so wird dafür im Messsignal P2 bei einem erfindungsgemässen Verfahren ein entsprechendes positives Signal erzeugt. Bei der Abfallflanke des Störsignals SP wird in entsprechender Weise im Messsignal P2 ein negatives Signal erzeugt. Das Messsignal P2 wird im Verstärker A3 verstärkt und auf die flankengesteuerten Setz-Eingänge der Flipflops F1, F2 geführt. Das Flipflop F1 spricht bei der ansteigenden Flanke des Störsignals SP an, das Flipflop F2 spricht bei der abfallenden Flanke des Störsignals SP an. Am Ausgang U erfolgt die Signalerfassung zu denselben Abtastzeitpunkten wie beim bekannten Verfahren nach Fig. 2. Zu diesen Abtastzeitpunkten an den Flanken des Grundtaktes CL wird das Signal SI nach dem bekannten Sampling-Verfahren abgetastet, d.h. ein bestimmter Phasenpunkt des Signals SI wird mehrmals hintereinander abgetastet.

Treten zwischen zwei solchen Abtastzeitpunkten, die mit den Flanken des Grundtaktes CL zusammenfallen, mindestens zwei Signalwechsel am Messsignal P2 auf, so werden beide Flipflops F1, F2 gesetzt. Der Ausgang S zeigt dann an, dass zwischen zwei solchen Abtastzeitpunkten, die mit den Taktflanken des Grundtaktes CL zusammenfallen, mindestens ein Störsignal aufgetreten ist. Die Ablaufsteuerung CON muss wenigstens nach jeder Taktflanke, nach der der abzutastende Phasenpunkt des Signals SI gewechselt soll, die Flipflops F1, F2 zurücksetzen.

Um das Messergebnis U2 zu erhalten, muss nach jeder Taktflanke des Grundtaktes CL, nachdem der Phasenpunkt des Signals SI gewechselt werden soll, neben dem Signal am Ausgang U auch die Störsignal-Anzeige S abgefragt werden. Bei der Wiedergabe des gemessenen Zustandsdiagrammes U2 müssen dann Zwischenbereiche, in denen mindestens ein Störsignal aufgetreten ist, gesondert markiert werden. In Fig. 4 ist beim Messergebnis U2 im schraffierten Bereich mindestens ein Störsignal aufgetreten.

### Patentansprüche

1. Verfahren zur Messung eines in einer Schaltung (PR) auftretenden elektrischen Signals (SI) bei dem das Signal (SI) mit Hilfe einer Sonde (PE) nach dem Sampling-Prinzip an verschiedenen Phasenpunkten jeweils mehrmals hintereinander abgetastet wird, bei dem die von der Sonde (PE) auf der Schaltung (PR) ausgelösten Sekundärteilchen (SE) nachgewiesen werden und bei dem aus einem Sekundärteilchensignal ein Messsignal (P2) erzeugt wird, dadurch gekennzeichnet, dass überprüft wird, ob im Phasenbereich zwischen einem ersten und einem nachfolgenden zweiten Phasenpunkt, an denen das Signal (SI) jeweils mehrmals hintereinander abgetastet wird, mindestens zwei Signalwechsel im Messsignal (P2) auftreten, wodurch ein Störsignal erkannt wird.

2. Verfahren nach Anspruch 1, dadurch gekennzeichnet, dass das mehrmalige Abtasten des Signals (SI) an Phasenpunkten vorgenommen wird, die mit einer ansteigenden oder einer abfallenden Flanke eines Grundtaktes (CL) der Schaltung (PR) übereinstimmen.

3. Vorrichtung zur Messung eines in einer Schaltung (PR) auftretenden elektrischen Signals (SI) mit einer Sonde (PE) zum Abtasten des Signals (SE), mit einem Detektor (DT) zum Nachweis der auf der Schaltung (PR) von der Sonde (PE) ausgelösten Sekundärteilchen (SE) und einer Signalkette (A1) zur Weiterverarbeitung eines im Detektor (DT) erzeugten Messsignals (P2), dadurch gekennzeichnet, dass zwei parallelgeschaltete flankengesteuerte Flipflops (F1, F2) vorgesehen sind, deren erste Eingänge mit einem Ausgang (P) der Signalkette (A1) derart verbunden sind, dass das erste Flipflop (F1) bei einer ansteigenden Flanke, das zweite Flipflop (F2) bei einer abfallenden Flanke des Messsignals (P2) gesetzt wird, dass die zweiten Eingänge der Flipflops (F1, F2) mit einem Ausgang (R) einer Ablaufsteuerung (CON) verbunden sind, so dass die Flipflops (F1, F2) nach jedem Abtasten eines Phasenpunktes des Signals (SI) zurückgesetzt werden und dass die Ausgänge der Flipflops (F1, F2) mit einer Einrichtung (G) derart verknüpft sind, dass der Ausgang (S) dieser Einrichtung (G) eine Störsignalanzeige darstellt, die aktiviert wird, wenn im Phasenbereich zwischen einem ersten und einem nachfolgenden zweiten Phasenpunkt, an denen das Signal jeweils mehrmals hintereinander abgetastet wird, mindestens zwei Signalwechsel im Messsignal (P2) auftreten.

### Claims

1. A method of measuring an electric signal (SI), occurring in a circuit (PR), in which the signal (SI) is sampled several times consecutively at different phase points by means of a probe (PE) in accordance with the sampling principle, wherein the secondary particles (SE), triggered by the probe (PE) on the circuit (PR), are detected, and wherein a measurement signal (P2) is produced from a secondary particle signal, characterised in that a check is made to determine whether at least two signal changes occur in the measurement signal (P2) in the phase zone between a first and a following second phase point at which the signal (SI) is sampled several times consecutively, by which means an interference signal is recognised.

2. A method as claimed in Claim 1, characterised in that the multiple sampling of the signal (SI) is carried out at phase points which coincide with a rising or falling flank of a fundamental clock signal (CL) of the circuit (PR).

3. A device for measuring an electric signal (SI), which occurs in a circuit (PR), by means of a probe (PE) which samples the signal (SE), a detector (DT) which detects the secondary particles (SE) triggered by the probe (PE) on the circuit (PR), and a signal chain (A1) which further processes a measurement signal (P2) generated in the detector (DT), characterised in that two parallel-connected flank-controlled flip-flops (F1, F2) are provided, the first inputs of which are connected to an output (P) of the signal chain (A1) in such manner that the first flip-flop (F1) is set with a rising flank of the measurement signal (P2), and the second flip-flop (F2) is set with a falling flank of the measurement signal (P2), that the second inputs of the flip-flops (F1, F2) are connected to an output (R) of a flow control unit (CON) so that the flip-flops (F1, F2) are reset following each sampling of a phase point of the signal (SI), and that the outputs of the flip-flops (F1, F2) are logic-linked to a device (G) in such manner that the output (S) of this device (G) represents an interference signal display which is activated when at least two signal changes occur in the measurement signal (P2) in the phase zone between a first and a following, second phase point at which the signal is sampled several times consecutively.

## Revendications

1. Procédé pour mesurer un signal électrique se présentant dans un circuit (PR), selon lequel le signal (SI) est échantillonné plusieurs fois de suite à différents points de phase à l'aide d'une sonde (PE), suivant le principe de l'échantillonnage, selon lequel les particules secondaires (SE) dont l'émission a été provoquée sur le circuit (PR) par la sonde (PE), sont détectées et selon lequel un signal de mesure (P2) est produit à partir d'un signal de particules secondaires, caractérisé en ce que l'on vérifie si, dans la région de phase comprise entre un premier point de phase et un second point de phase suivant, auxquels le signal (SI) est chaque fois échantillonné plusieurs fois de suite, apparaissent au moins deux transitions de signal dans le signal de mesure (P2), transitions par lesquelles est détecté un signal parasite.

2. Procédé selon la revendication 1, caractérisé en ce que l'échantillonnage du signal (SI) à plusieurs reprises est opéré à des points de phase qui correspondent à un flanc montant ou un flanc descendant d'un rythme de base (CL) du circuit (PR).

3. Dispositif pour mesurer un signal électrique (SI) se présentant dans un circuit (PR), comprenant une sonde (PE) pour l'échantillonnage du signal (SE), un détecteur (DT) pour détecter les particules secondaires (SE) dont l'émission a été provoquée sur le circuit (PR) par la sonde (PE), ainsi qu'une chaîne de signal (A1) pour le traitement consécutif d'un signal de mesure (P2) généré dans le détecteur (DT), caractérisé par la prévision de deux bascules (F1, F2) montées en parallèle et à commande par transition, dont des premières entrées sont connectées à une sortie (P) de la chaîne de signal (A1) de manière que la première bascule (F1) soit mise à 1 à un flanc montant et la seconde bascule (F2) soit miese à 1 à un flanc descendant du signal de mesure (P2), que les secondes entrées des bascules (F1, F2) sont connectées à une sortie (R) d'une commande séquentielle (CON) de manière que les bascules (F1, F2) soient remises à 0 après chaque échantillonnage d'un point de phase du signal (SI) et que les sorties de bascule (F1, F2) sont connectées logiquement à un dispositif (G) de manière que la sortie (S) de ce dispositif (G) représente un élément indicateur de signal parasite, élément qui est activé lorsque, dans une région de phase comprise entre un premier point de phase un second point de phase suivant, auxquels le signal est échantillonné plusieurs fois de suite, apparaissent au moins deux transitions de signal dans le signal de mesure (P2).

# FIG 1

# FIG 2

CL

SI

SP

EP

P1

U1

# FIG 3

PH

t →

# FIG 4

P2

U2

# FIG 5

PH

t —→